(19) Europäisches Patentamt

European Patent Office

Office européen des brevets

(11) **EP 1 230 729 B1**

(12) **EUROPÄISCHE PATENTSCHRIFT**

(45) Veröffentlichungstag und Bekanntmachung des Hinweises auf die Patenterteilung:
**27.08.2003 Patentblatt 2003/35**

(21) Anmeldenummer: 00993060.3

(22) Anmeldetag: **07.11.2000**

(51) Int Cl.⁷: **H03B 28/00**

(86) Internationale Anmeldenummer:
**PCT/EP00/10990**

(87) Internationale Veröffentlichungsnummer:
**WO 01/035524 (17.05.2001 Gazette 2001/20)**

(54) **SCHALTUNGSANORDNUNG ZUR ERZEUGUNG VON SIGNALFORMEN**

CIRCUIT ARRANGEMENT FOR PRODUCING SIGNAL FORMS

MONTAGE POUR LA PRODUCTION DE FORMES DE SIGNAUX

(84) Benannte Vertragsstaaten:
**DE FR GB IT**

(30) Priorität: **09.11.1999 DE 19953884**

(43) Veröffentlichungstag der Anmeldung:
**14.08.2002 Patentblatt 2002/33**

(73) Patentinhaber: **Infineon Technologies AG
81669 München (DE)**

(72) Erfinder: **KRANZ, Christian
40885 Ratingen Lintorf (DE)**

(74) Vertreter: **Banzer, Hans-Jörg, Dipl.-Ing.
Kraus & Weisert
Patent- und Rechtsanwälte
Thomas-Wimmer-Ring 15
80539 München (DE)**

(56) Entgegenhaltungen:
**US-A- 4 353 115**

**Beschreibung**

Die vorliegende Erfindung betrifft eine Schaltungsanordnung zur Erzeugung von bestimmten Signalformen, insbesondere von Signalformen, die zur Tonerzeugung in (Mobil-)Telefonen verwendet werden können.

Zur Tonerzeugung in Telefonen ist die Erzeugung eines Signals mit einer beliebigen Signalform und einer einstellbaren Spannungshöhe (Amplitude) erforderlich. Das auf diese Weise erzeugte Signal kann dann beispielsweise mit Hilfe von kapazitiven Schallwandlern in Schallwellen umgesetzt werden.

Insbesondere für einen Mehrtonruf, wie er heutzutage in modernen Telefonen verwendet wird, ist daher ein Schaltungsanordnung erforderlich, die das zuvor beschriebene Signal mit der gewünschten Signalform erzeugen kann. Bekannte Schaltungsanordnungen verwenden hierzu eine relativ hohe konstante Versorgungsspannung, um daraus mit Hilfe eines geeigneten Spannungswandlers das gewünschte Signal abzuleiten.

Das amerikanische Patent US-A-4 353 115 offenbart eine Schaltungsanordnung gemäß dem Oberbegriff des Anspruchs 1.

Der vorliegenden Erfindung liegt die Aufgabe zugrunde, eine Schaltungsanordnung zur Erzeugung von Signalformen bereitzustellen, welche mit relativ einfachen Mitteln und hoher Zuverlässigkeit bzw. Genauigkeit ein Signal mit einer gewünschten Signalform erzeugen kann.

Diese Aufgabe wird erfindungsgemäß durch eine Schaltungsanordnung mit den Merkmalen des Anspruches 1 gelöst. Die Unteransprüche definieren vorteilhafte und bevorzugte Ausführungsformen der vorliegenden Erfindung.

Erfindungsgemäß wird eine Spannungswandlerschaltung verwendet, der ein erstes und ein zweites Steuersignal zugeführt wird. Die Spannungswandlerschaltung ist mit einer Möglichkeit sowohl zur Spannungserhöhung als auch zur Spannungsabsenkung ausgestaltet, wobei die Ausgangsspannung der Spannungswandlerschaltung abhängig von dem ersten Steuersignal erhöht und abhängig von dem zweiten Steuersignal reduziert wird.

Die Ansteuerung der Spannungswandlerschaltung erfolgt bevorzugt über eine Einstellung der Frequenz und/oder Pulsweite der beiden Steuersignale, wobei die Frequenz und/oder die Pulsweite der Steuersignale in Abhängigkeit von einem Referenzsignal so geregelt oder eingestellt wird, daß am Ausgang der Spannungswandlerschaltung die gewünschte Signalform auftritt.

Die erfindungsgemäße Schaltungsanordnung kann sowohl in Form einer "Open Loop Control" ohne Rückkopplung der Ausgangsspannung der Spannungswandlerschaltung als auch in Form eines Regelkreises ("Closed Loop Control") mit Rückkopplung der Ausgangsspannung der Spannungswandlerschaltung ausgestaltet sein. Im ersten Fall kann eine Reduzierung des Schaltungsaufwands erzielt werden, während im zweiten Fall die Signalform des Ausgangssignal der Spannungswandlerschaltung genauer erzeugt werden kann.

Die vorliegende Erfindung wird nachfolgend unter Bezugnahme auf die beigefügte Zeichnung anhand eines bevorzugten Ausführungsbeispiels näher erläutert.

Fig. 1 zeigt ein schematisches Blockschaltbild einer Schaltungsanordnung zur Erzeugung von Signalformen gemäß einem Ausführungsbeispiel der vorliegenden Erfindung,

Fig. 2 zeigt eine mögliche schaltungstechnische Realisierung eines in Fig. 1 dargestellten Spannungswandlers, und

Fig. 3A und 3B zeigen Signalverläufe in der in Fig. 1 gezeigten Schaltungsanordnung zur Erläuterung deren Betriebs.

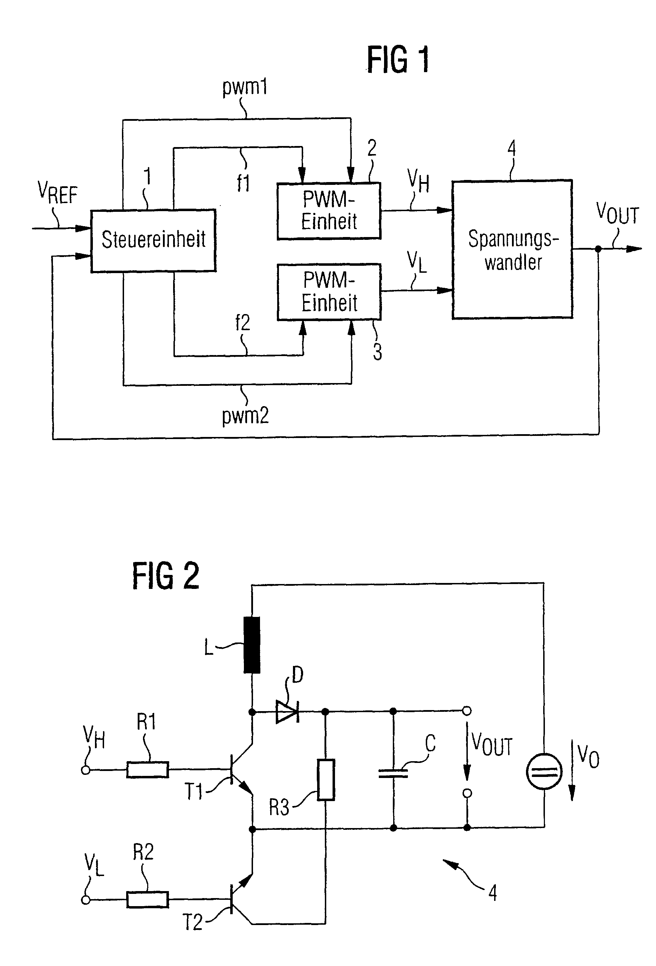

Die in Fig. 1 gezeigte Schaltungsanordnung, welche beispielsweise zur Mehrtonruferzeugung in Mobiltelefonen eingesetzt werden kann, umfaßt einen DC/DC-Spannungswandler 4, der in Form eines mit einer Möglichkeit zur Spannungsabsenkung versehenen DC/DC-Aufwärtsreglers gebildet sein kann. Der Spannungswandler 4 ist somit in der Lage, seine Ausgangsspannung $V_{OUT}$ sowohl zu erhöhen als auch abzusenken.

Die Ansteuerung des Spannungswandlers 4 zur Einstellung der Signalform seines Ausgangssignals $V_{OUT}$ erfolgt über zwei Steuersignale $V_H$ und $V_L$, wobei die Ausgangsspannung $V_{OUT}$ über das Steuersignal $V_H$ erhöht und über das Steuersignal $V_L$ abgesenkt wird. Jedes Steuersignal $V_H$ bzw. $V_L$ wird von einer entsprechenden Pulsweitenmodulationseinheit (PWM-Einheit) 2 bzw. 3 generiert, welche die Frequenz und/oder die Pulsweite des jeweiligen pulsförmigen Steuersignals abhängig von Einstellsignalen einstellt, die von einer Steuereinheit 1 vorgegeben werden.

Die Steuereinheit 1 empfängt ein Referenzsignal $V_{REF}$ und vergleicht dieses mit dem Istwert des Ausgangssignals $V_{OUT}$. Abhängig von dem Vergleichsergebnis werden Pulsweiteneinstellsignale pwm1 bzw. pwm2 zur Einstellung der Pulsweite und/oder Frequenzeinstellsignale f1 bzw. f2 zur Einstellung der Frequenz des Steuersignals $V_H$ und $V_L$ generiert, die der PWM-Einheit 2 bzw. der PWM-Einheit 3 vorgegeben werden, so daß die PWM-Einheiten 2 und 3 die Steuersignale $V_H$ und $V_L$ abhängig von den jeweils vorgegeben Einstellwerten erzeugen können. Auf diese Weise wird die Pulsweite und/oder die Frequenz der pulsförmigen Steuersignale $V_H$ und $V_L$ in Abhängigkeit von dem Referenzsignal $V_{REF}$ derart geregelt oder eingestellt, daß am Ausgang des Spannungswandlers die gewünschte Signalform auftritt, wobei die Ausgangsspannung $V_{OUT}$ durch Pulse an dem dem Steuersignal $V_H$ zugeordneten Eingang des Spannungswandlers 4 erhöht wird, während sie durch Pulse an dem dem Steuersignal $V_L$ zugeordneten Eingang erniedrigt wird. Die in Fig. 1 gezeigte Schaltungsanordnung entspricht somit im Prinzip einem deltamodulierten DC/DC-Wandler.

In Fig. 2 ist eine mögliche Realsisierung des Spannungswandlers 4 dargestellt, wobei der Spannungswandler 4 durch eine mit einer Versorgungsspannung $V_0$ betriebene und aus zwei Bipolartransistoren T1, T2, einer Spule L, einer Diode D, einen Kondensator C und Widerständen R1-R3 bestehende Schaltung gebildet ist. Die einzelnen Bauelemente sind wie in Fig. 2 gezeigt verschaltet, wobei das Steuersignal $V_H$ über den Anschlußwiderstand R1 an den Basisanschluß des Bipolartransistors T1 und das Steuersignal $V_L$ über den Anschlußwiderstand R2 an den Basisanschluß des Bipolartransistors T2 angelegt ist. Die Ausgangsspannung $V_{OUT}$ kann an dem Kondensator C abgegriffen werden. Wie bereits erwähnt worden ist, wird die Ausgangsspannung $V_{OUT}$ durch $V_H$-Pulse am Bipolartransistor T1 erhöht, während sie durch $V_L$-Pulse am Bipolartransistor T2 erniedrigt wird.

Durch die Steuereinheit 1 kann entweder die Pulsweite oder die Frequenz oder aber auch sowohl die Pulsweite als auch die Frequenz der beiden Steuersignale $V_H$ und $V_L$ eingestellt werden, wobei in jedem dieser Fälle die Funktionsfähigkeit der in Fig. 1 gezeigten Schaltungsanordnung gewährleistet ist.

Der Einfachheit soll nachfolgend ein Ausführungsbeispiel näher erläutert werden, bei dem die beiden PWM-Einheiten 2 und 3 mit einer konstanten Frequenz betrieben werden, so daß durch die Steuereinheit 1 und die PWM-Einheiten 2 und 3 lediglich die Pulsweite der beiden Steuersignale $V_H$ und $V_L$ eingestellt wird. Dabei kann die Pulsweite auf digitale Weise mit Hilfe von Zählern eingestellt werden, die mit einem höheren Takt betrieben werden. Die Frequenz der beiden PWM-Einheiten 2 und 3 kann beispielsweise 128kHz betragen, während der Zählertakt 10,368MHz beträgt, so daß sich entsprechend 81 verschiedene Pulsweiten für die beiden Steuersignale $V_H$ und $V_L$ ergeben.

Die Steuereinheit 1 arbeitet digital und bestimmt die von den beiden PWM-Einheiten 2 und 3 einzustellende Pulsweite aus dem Differenzsignal $e(k)$ des Referenzsignals $x(k)$ und des Ausgangssignals $y(k)$, d.h. $e(k) = x(k) - y(k)$, wobei k jeweils den Abtastzeitpunkt bezeichnet. Die Steuereinheit 1 bestimmt den Wert der Pulsweite PW abhängig von dem Differenzsignal $e(k)$ wie folgt:

Für $e(k) > 0$:

$$ PW \;=\; \sqrt{2 \cdot C \cdot L \cdot \big(2 \cdot e(k) \cdot y(k) + e(k) \cdot e(k)\big)} \,/\, \big(T \cdot V_0\big) $$

Für $e(k) < 0$:

$$ PW \;=\; -R \cdot C \cdot \ln\!\big(y(k) \,/\, (y(k) + e(k))\big)/T $$

Dabei bezeichnet C den Wert des in Fig. 2 gezeigten Kondensators, L den Wert der in Fig. 2 gezeigten Spule, R den Wert des in Fig. 2 gezeigten Widerstands R3, 1/T die Frequenz der PWM-Einheiten 2 und 3 bzw. der beiden Steuersignale $V_H$ und $V_L$ und $V_0$ den Wert der in Fig. 2 gezeigten Versorgungsspannung. Zur Reduzierung des Realisierungsaufwands empfiehlt es sich, die obigen Werte für die Pulsweite PW approximativ, beispielsweise mit Hilfe einer Polynomapproximation, zu ermitteln.

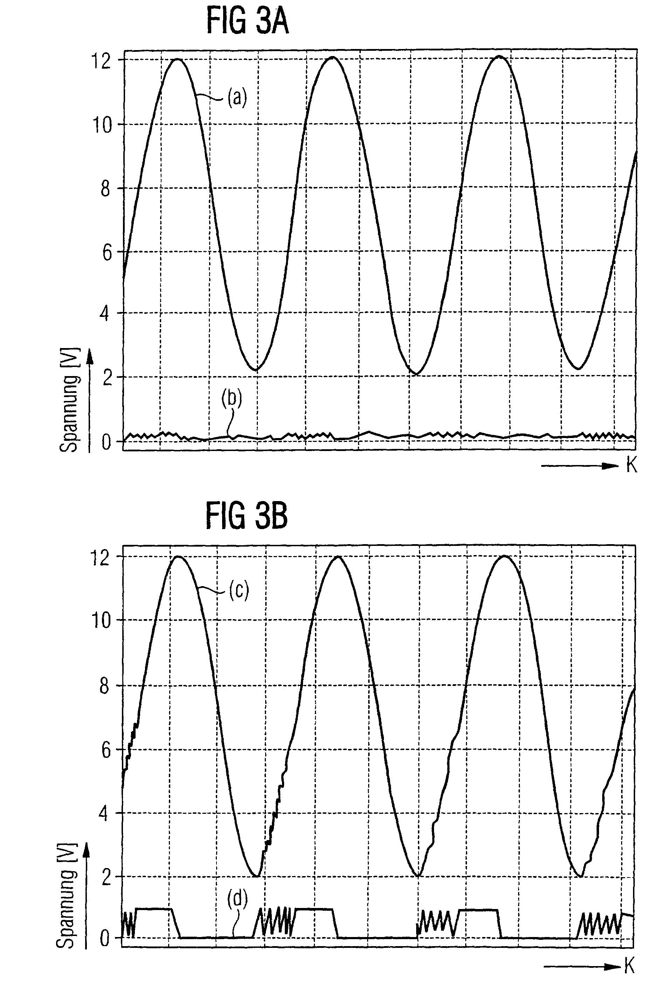

In Fig. 3A und 3B sind verschiedene Signalverläufe der in Fig. 1 gezeigten Schaltungsanordnung für verschiedene diskrete Abtastzeitpunkte k mit C = 30nF, L = 47µH, R = 330Ω, $V_0$ = 2,65V und T = 1/128kHz dargestellt. Dabei entspricht in Fig. 3A der Signalverlauf (a) dem Referenzsignal $V_{REF}$ und der Signalverlauf (b) dem Signal pwm1 bzw. pwm2, während in Fig. 3B der Signalverlauf (c) dem Ausgangssignal $V_{OUT}$ und der Signalverlauf (d) den Steuerspannungen $V_H/V_L$ mit $V_H$ = "1" und $V_L$ = "0" entspricht.

Eine Reduzierung des Schaltungaufwands kann erreicht werden, wenn die beiden Steuersignale $V_H$ und $V_L$ ohne Rückkopplung, d.h. ohne Auswertung der Ausgangsspannung $V_{OUT}$ des Spannungswandlers 4 erzeugt werden. In diesem Fall erfolgt somit keine Regelung ("Closed Loop"), sondern lediglich eine Steuerung ("Open Loop"), wobei die Steuereinheit 1 bei konstanter Frequenz der PWM-Einheiten 2 und 3 den Wert der Pulsweite PW abhängig von dem Referenzsignal $x(k)$ wie folgt bestimmt:

Für $x(k) > x(k-1)$:

$$PW \;=\; -\frac{L}{R_{EC} \cdot T} \cdot \ln\!\left( 1 - \frac{R_{EC}}{V_o} \cdot \sqrt{\frac{C}{L}\left(x^2(k) - x^2(k-1)\right)}\,\right)$$

Für x(k) < x(k-1):

$$PW \;=\; -\frac{R \cdot C}{T} \cdot \Big( \ln(x(k-1)) - \ln(x(k)) \Big)$$

$R_{EC}$ bezeichnet in den obigen Formeln den Emitter-Kollektor-Widerstand des Bipolartransistors T1.

**Patentansprüche**

1. Schaltungsanordnung zur Erzeugung von Signalformen, mit einer Spannungswandlerschaltung (4) zur Erzeugung eines Ausgangssignal ($V_{OUT}$) mit einer bestimmten Signalform,
   wobei Steuermittel (1-3) zur Ansteuerung der Spannungswandlerschaltung (4) vorgesehen sind, wobei die Steuermittel (1-3) ein erstes Steuersignal ($V_H$) und ein zweites Steuersignal ($V_L$) zur Ansteuerung der Spannungswandlerschaltung (4) erzeugen, **dadurch gekennzeichnet,**
   **daß** die Spannungswandlerschaltung (4) derart ausgestaltet ist, daß sie die Spannung ihres Ausgangssignals abhängig von dem ersten Steuersignal ($V_H$) erhöht und abhängig von dem zweiten Steuersignal ($V_L$) absenkt.

2. Schaltungsanordnung nach Anspruch 1,
   **dadurch gekennzeichnet,**
   **daß** die Steuermittel (1-3) derart ausgestaltet sind, daß sie das erste und zweite Steuersignal ($V_H$, $V_L$) für die Spannungswandlerschaltung (4) mit einer variablen Pulsweite erzeugen.

3. Schaltungsanordnung nach Anspruch 2,
   **dadurch gekennzeichnet,**
   **daß** die Steuermittel (1-3) eine Steuereinheit (1) und eine erste und eine zweite Pulsweitenmodulationseinheit (2, 3) umfassen,
   wobei die Steuereinheit (1) derart ausgestaltet ist, daß sie ein Einstellsignal (pwm1) für die erste Pulsweitenmodulationseinheit (2) und ein Einstellsignal (pwm2) für die zweite Pulsweitenmodulationseinheit (3) erzeugt,
   wobei die erste bzw. zweite Pulsweitenmodulationseinheit (2, 3) derart ausgestaltet ist, daß sie abhängig von dem entsprechenden Einstellsignal (Pwm1, pwm2) die Pulsweite des der Spannungswandlerschaltung (4) zugeführten ersten bzw. zweiten Steuersignals ($V_H$, $V_L$) einstellt, und
   wobei die Spannungswandlerschaltung (4) derart ausgestaltet ist, daß sie die Spannung ihres Ausgangssignals ($V_{OUT}$) in Abhängigkeit von der Pulsweite des von der ersten Pulsweitenmodulationseinheit (2) zugeführten ersten Steuersignals ($V_H$) erhöht bzw. in Abhängigkeit von der Pulsweite des von der zweiten Pulsweitenmodulationseinheit (3) zugeführten zweiten Steuersignals ($V_L$) absenkt.

4. Schaltungsanordnung nach einem der vorhergehenden Ansprüche,
   **dadurch gekennzeichnet,**
   **daß** die Steuermittel (1-3) derart ausgestaltet sind, daß sie das erste und zweite Steuersignal ($V_H$, $V_L$) für die Spannungswandlerschaltung (4) mit einer variablen Frequenz erzeugen.

5. Schaltungsanordnung nach Anspruch 4,
   **dadurch gekennzeichnet,**
   **daß** die Steuermittel (1-3) eine Steuereinheit (1) und eine erste und eine zweite Pulsweitenmodulationseinheit (2, 3) umfassen,
   **daß** die Steuereinheit (1) derart ausgestaltet ist, daß sie ein Einstellsignal (f1) für die erste Pulsweitenmodulationseinheit (2) und ein Einstellsignal (f2) für die zweite Pulsweitenmodulationseinheit (3) erzeugt,
   wobei die erste bzw. zweite Pulsweitenmodulationseinheit (2, 3) derart ausgestaltet ist, daß sie abhängig von dem entsprechenden Einstellsignal (f1, f2) die Frequenz der der Spannungswandlerschaltung (4) zugeführten ersten bzw. zweiten Steuersignals ($V_H$, $V_L$) einstellt, und

wobei die Spannungswandlerschaltung (4) derart ausgestaltet ist, daß sie die Spannung ihres Ausgangssignals ($V_{OUT}$) in Abhängigkeit von der Frequenz des von der ersten Pulsweitenmodulationseinheit (2) zugeführten ersten Steuersignals ($V_H$) erhöht bzw. in Abhängigkeit von der Frequenz des von der zweiten Pulsweitenmodulationseinheit (3) zugeführten zweiten Steuersignals ($V_L$) absenkt.

6. Schaltungsanordnung nach einem der vorhergehenden Ansprüche
**dadurch gekennzeichnet,**
**daß** die Spannungswandlerschaltung (4) eine mit einer Versorgungsspannung ($V_0$) betriebene Serienschaltung aus einer Induktivität (L) und einem ersten steuerbaren Halbleiterschalter (T1) umfaßt,
wobei parallel zu dem ersten steuerbaren Halbleiterschalter (T1) eine Serienschaltung aus einem Gleichrichtelement (D) und einer Kapazität (C) geschaltet ist und an der Kapazität die Spannung des Ausgangssignals ($V_{OUT}$) der Spannungswandlerschaltung (4) abgreifbar ist,
wobei parallel zu der Kapazität (C) ein zweiter steuerbarer Halbleiterschalter (T2) geschaltet ist, und
wobei der erste steuerbare Halbleiterschalter (T1) von dem ersten Steuersignal ($V_H$) und der zweite steuerbare Halbleiterschalter (T2) von dem zweiten Steuersignal ($V_L$) angesteuert wird.

7. Schaltungsanordnung nach Anspruch 6,
**dadurch gekennzeichnet,**
**daß** der erste und zweite steuerbare Halbleiterschalter jeweils durch einen Bipolartransistor (T1, T2) gebildet ist,
wobei der Emitter des den ersten Halbleiterschalter bildenden ersten Bipolartransistors (T1) mit dem Emitter des den zweiten Halbleiterschalter bildenden zweiten Bipolartransistors (T2) verbunden ist,
wobei der Kollektor des ersten Bipolartransistors (T1) mit dem einen Anschluß des Gleichrichtelements (D) und der Kollektor des zweiten Bipolartransistors (T2) über einen Widerstand (R3) mit dem anderen Anschluß des Gleichrichtelements (D) verbunden ist, und
wobei an die Basis des ersten Bipolartransistors (T1) das erste Steuersignal ($V_H$) und an das Basis des zweiten Bipolartransistors (T2) das zweite Steuersignal ($V_L$) angelegt ist.

8. Schaltungsanordnung nach Anspruch 7 und Anspruch 3,
**dadurch gekennzeichnet,**
**daß** die Steuermittel (1-3) derart ausgestaltet sind, daß sie das erste und zweite Steuersignal ($V_H$, $V_L$) für die Spannungswandlerschaltung (4) ohne Auswertung des Ausgangssignals ($V_{OUT}$) der Spannungswandlerschaltung (4), jedoch in Abhängigkeit von einem Referenzsignal ($V_{REF}$) erzeugen,
**daß** die erste bzw. zweite Pulsweitenmodulationseinheit (2, 3) das erste bzw. zweite Steuersignal ($V_H$, $V_L$) mit einer konstanten Frequenz erzeugen,
**daß** die Steuereinheit (1) derart ausgestaltet ist, daß sie die Pulsweite der ersten bzw. zweiten Pulsweitenmodulationseinheit (2, 3) zumindest näherungsweise entsprechend dem Ausdruck

$$-\frac{L}{R_{EC} \cdot T} \cdot \ln\left(1 - \frac{R_{EC}}{V_o} \cdot \sqrt{\frac{C}{L}\left(x^2(k) - x^2(k-1)\right)}\right)$$

bestimmt, falls x(k) > x(k-1) ist, während sie die Pulsweite der ersten bzw. zweiten Pulsweitenmodulationseinheit (2, 3) zumindest näherungsweise entsprechend dem Ausdruck

$$-\frac{R \cdot C}{T} \cdot \left(\ln(x(k-1)) - \ln(x(k))\right)$$

bestimmt, falls x(k) < x(k-1) ist,
wobei C den Wert der Kapazität, L den Wert der Induktivität, R den Wert des Widerstands, $R_{EC}$ den Wert des Emitter-Kollektor-Widerstands des ersten Bipolartransistors (T1), $V_0$ den Wert der Versorgungsspannung, 1/T den Wert der Frequenz der ersten und zweiten Pulsweitenmodulationseinheit (2, 3) und x(k) den Wert des Referenzsignals zum Zeitpunkt k und bezeichnet.

9. Schaltungsanordnung nach einem der Ansprüche 1-7,
**dadurch gekennzeichnet,**

**daß** die Steuermittel (1-3) derart ausgestaltet sind, daß sie das Ausgangssignal ($V_{OUT}$) der Spannungswandlerschaltung (4) mit einem Referenzsignal ($V_{REF}$) vergleichen und abhängig von dem Vergleichsergebnis das erste und zweite Steuersignal ($V_H$, $V_L$) für die Spannungswandlerschaltung (4) erzeugen.

**10.** Schaltungsanordnung nach Anspruch 9 und Anspruch 3 oder 5,
**dadurch gekennzeichnet,**
**daß** die Steuereinheit (1) derart ausgestaltet ist, daß sie das Ausgangssignal ($V_{OUT}$) der Spannungswandlerschaltung (4) mit dem Referenzsignal ($V_{REF}$) vergleicht und abhängig von dem Vergleichsergebnis das Einstellsignal (pwm1, f1) für die erste Pulsweitenmodulationseinheit (2) und das Einstellsignal (pwm2, f2) für die zweite Pulsweitenmodulationseinheit (3) erzeugt.

**11.** Schaltungsanordnung nach Anspruch 7 und Anspruch 10,
**dadurch gekennzeichnet,**
**daß** die erste bzw. zweite Pulsweitenmodulationseinheit (2, 3) das erste bzw. zweite Steuersignal ($V_H$, $V_L$) mit einer konstanten Frequenz erzeugen,
**daß** die Steuereinheit (1) derart ausgestaltet ist, daß sie die Pulsweite der ersten bzw. zweiten Pulsweitenmodulationseinheit (2, 3) zumindest näherungsweise entsprechend dem Ausdruck

$$\sqrt{2 \cdot C \cdot L \cdot \left( 2 \cdot e(k) \cdot y(k) + e(k) \cdot e(k) \right)} / \left( T \cdot V_0 \right)$$

bestimmt, falls
e(k) > 0 ist, während sie die Pulsweite der ersten bzw. zweiten Pulsweitenmodulationseinheit (2, 3) zumindest näherungsweise entsprechend dem Ausdruck

$$- R \cdot C \cdot \ln\left( y(k) / (y(k) + e(k)) \right) / T$$

bestimmt, falls e(k) < 0 ist,
wobei C den Wert der Kapazität, L den Wert der Induktivität, R den Wert des Widerstands, $V_0$ den Wert der Ver-sorgungsspannung, 1/T den Wert der Frequenz der ersten und zweiten Pulsweitenmodulationseinheit (2, 3), e(k) den Wert des Differenzsignals zum Zeitpunkt k und y(k) den Wert des Ausgangssignals der Signalwandlerschaltung (4) zum Zeitpunkt k bezeichnet.

**12.** Schaltungsanordnung nach Anspruch 11,
**dadurch gekennzeichnet,**
**daß** die Frequenz der ersten und zweiten Pulsweitenmodulationseinheiten (2, 3) 128 kHz beträgt.

**13.** Verwendung einer Schaltungsanordnung nach einem der vorhergehenden Ansprüche zur Tonerzeugung in einem Telefon.

**Claims**

**1.** Circuit arrangement for generating waveforms,
having a voltage transformer circuit (4) for generating an output signal ($V_{OUT}$) with a specific waveform,
wherein control means (1-3) are provided for activating the voltage transformer circuit (4), the control means (1-3) generating a first control signal ($V_H$) and a second control signal ($V_L$) to activate the voltage transformer circuit (4),
**characterised in that**
the voltage transformer circuit (4) is configured so that the voltage of its output signal is increased depending on the first control signal ($V_H$) and reduced depending on the second control signal ($V_L$).

**2.** Circuit arrangement as claimed in claim 1,
**characterised in that**
the control means (1-3) are configured so that they generate the first and second control signal ($V_H$, $V_L$) for the voltage transformer circuit (4) with a variable pulse width.

3.  Circuit arrangement as claimed in claim 2,
    **characterised in that**
    the control means (1-3) comprise a control unit (1) and a first and a second pulse width modulation unit (2, 3),
    **in that** the control unit (1) is configured so as to generate a modulation signal (pwm1) for the first pulse width modulation unit (2) and a modulation signal (pwm2) for the second pulse width modulation unit (3),
    **in that** the first and second pulse width modulation unit (2, 3) are configured so that they modulate the pulse width of the respective first and second control signal ($V_H$, $V_L$) of the voltage transformer circuit (4) depending on the corresponding modulation signal (pwm1, pwm2), and
    **in that** the voltage transformer circuit (4) is configured so that it increases the voltage of its output signal ($V_{OUT}$) depending on the pulse width of the first control signal ($V_H$) applied by the first pulse width modulation unit (2) and reduces the pulse width depending on the pulse width of the second control signal ($V_L$) applied by the second pulse width modulation unit (3).

4.  Circuit arrangement as claimed in one of the preceding claims,
    **characterised in that**
    the control means (1-3) are configured so that they generate the first and second control signal ($V_H$, $V_L$) for the voltage transformer circuit (4) with a variable frequency.

5.  Circuit arrangement as claimed in claim 4,
    **characterised in that**
    the control means (1-3) comprise a control unit (1) and a first and a second pulse width modulation unit (2, 3),
    **in that** the control unit (1) is configured so as to generate a modulation signal (f1) for the first pulse width modulation unit (2) and a modulation signal (f2) for the second pulse width modulation unit (3),
    **in that** the first and second pulse width modulation unit (2, 3) are configured so that they modulate the frequency of the first and second control signal ($V_H$, $V_L$) applied to the voltage transformer unit depending on the corresponding modulation signal (f1, f2) and
    **in that** the voltage transformer unit (4) is configured so that it increases the voltage of its output signal ($V_{OUT}$) depending on the frequency of the first control signal ($V_H$) from the first pulse width modulation unit (2) and decreases it depending on the frequency of the control signal ($V_L$) from the second pulse width modulation unit (3).

6.  Circuit arrangement as claimed in one of the preceding claims,
    **characterised in that**
    the voltage transformer circuit (4) comprises a series circuit operated with a supply voltage ($V_0$) consisting of an inductance coil (L) and a first controllable semiconductor switch (T1),
    **in that** a series circuit consisting of a rectifier element (D) and a capacitor (C) is connected in parallel with the first controllable semiconductor switch (T1), it being possible to tap the voltage of the output signal ($V_{OUT}$) of the voltage transformer circuit (4) from the capacitor,
    a second controllable semiconductor switch (T2) being connected in parallel with the capacitor (C) and
    the first controllable semiconductor switch (T1) being activated by the first control signal ($V_H$) and the second controllable semiconductor switch (T2) being activated by the second control signal ($V_L$).

7.  Circuit arrangement as claimed in claim 6,
    **characterised in that**
    the first and second controllable semiconductor switches are each provided as a bipolar transistor (T1, T2),
    **in that** the emitter of the first bipolar transistor (T1) forming the first semiconductor switch is connected to the emitter of the second bipolar transistor (T2) forming the second semiconductor switch,
    **in that** the collector of the first bipolar transistor (T1) is connected to the one terminal of the rectifier element (D) and the collector of the second bipolar transistor (T2) is connected via a resistor (R3) to the other terminal of the rectifier element (D) and
    **in that** the first control signal ($V_H$) is applied to the base of the first bipolar transistor (T1) and the second control signal ($V_L$) is applied to the base of the second bipolar transistor (T2).

8.  Circuit arrangement as claimed in claim 7 and claim 3,
    **characterised in that**
    the control means (1-3) are configured so that they generate the first and second control signals ($V_H$, $V_L$) for the voltage transformer circuit (4) without evaluating the output signal ($V_{OUT}$) of the voltage transformer circuit (4) but do so depending on a reference signal ($V_{REF}$),
    **in that** the first and second pulse width modulation units (2, 3) generate the first and second control signal ($V_H$,

$V_L$), respectively, at a constant frequency,
**in that** the control unit (1) is configured so that it defines the pulse width of the first and second pulse width modulation units (2, 3) at least approximately on the basis of the expression

$$-\frac{L}{R_{EC} \cdot T} \cdot \ln\left(1 - \frac{R_{EC}}{V_0} \cdot \sqrt{\frac{C}{L}(x^2(k) = x^2(k-1))}\right)$$

if x(k) > x(k-1), whilst the pulse width of the first and second pulse width modulation units (2, 3) is defined at least approximately on the basis of the expression

$$-\frac{R \cdot C}{T} \cdot \big(\ln(x(k-1)) - \ln(x(k))\big)$$

if x(k) < x(k-1),
where C is the value of the capacitance, L the value of the inductance, R the value of the resistance, $R_{EC}$ the value of the emitter-collector resistance of the first bipolar transistor (T1), $V_0$ is the value of the supply voltage, 1/T is the value of the frequency of the first and second pulse width modulation units (2, 3) and x(k) is the value of the reference signal at the time k.

9. Circuit arrangement as claimed in one of claims 1-7,
**characterised in that**
the control means (1-3) are configured so that they compare the output signal ($V_{OUT}$) of the voltage transformer circuit (4) with a reference signal ($V_{REF}$) and generate the first and second control signal ($V_H$, $V_L$) for the voltage transformer circuit (4) depending on the result of the comparison.

10. Circuit arrangement as claimed in claim 9 and claim 3 or 5,
**characterised in that**
the control unit (1) is configured so that it compares the output signal ($V_{OUT}$) of the voltage transformer circuit (4) with the reference signal ($V_{REF}$) and generates the modulation signal (pwm1, f1) for the first pulse width modulation unit (2) and the modulation signal (pwm2, f2) for the second pulse width modulation unit (3) depending on the result of the comparison.

11. Circuit arrangement as claimed in claim 7 and claim 10,
**characterised in that**
the first and second pulse width modulation unit (2, 3) generates the first and second control signal ($V_H$, $V_L$), respectively, at a constant frequency,
**in that** the control unit (1) is configured so that it defines the pulse width of the first and second pulse width modulation units (2, 3) at least approximately on the basis of the expression $\sqrt{2 \cdot C \cdot L \cdot (2 \cdot e(k) \cdot y(k) + e(k) \cdot e(k))}/(T \cdot V_0)$ if e(k) > 0, whilst the pulse width of the first and second pulse width modulation units (2, 3) is generated at least approximately on the basis of the expression $-R \cdot C \cdot \ln(y(k)/(y(k)+e(k)))/T$ if e(k) < 0,
where C is the value of the capacitance, L the value of the inductance, R the value of the resistance, $V_0$ is the value of the supply voltage, 1/T is the value of the frequency of the first and second pulse width modulation units (2, 3), e(k) is the value of the differential signal at the time k and y(k) is the value of the output signal of the signal transformer circuit (4) at the time k.

12. Circuit arrangement as claimed in claim 11,
**characterised in that** the frequency of the first and second pulse width modulation units (2, 3) is 128 kHz.

13. Use of a circuit arrangement as claimed in one of the preceding claims to generate sounds in a telephone.

**Revendications**

1. Montage pour générer des formes de signaux comprenant un circuit transformateur de tension (4) servant à fournir un signal de sortie ($V_{OUT}$) ayant une forme de signal déterminée, des éléments de commande (1-3) pour l'activation du circuit transformateur de tension (4) étant prévus et les éléments de commande (1-3) fournissant un premier signal de commande ($V_H$) et un deuxième signal de commande ($V_L$) pour l'activation du circuit à transformateurs de tension (4), **caractérisé en ce que** le circuit transformateur de tension (4) est configuré de telle façon qu'il relève la tension de son signal de sortie en fonction du premier signal de commande ($V_H$) et l'abaisse en fonction du deuxième signal de commande ($V_L$).

2. Montage selon la revendication 1, **caractérisé en ce que** les éléments de commande (1-3) sont configurés de telle façon qu'ils génèrent le premier et le deuxième signal de commande ($V_H$, $V_L$) pour le circuit transformateur de tension (4) avec une largeur d'impulsion variable.

3. Montage selon la revendication 2, **caractérisé en ce que** les éléments de commande (1-3) comprennent une unité de commande (1) et une première ainsi qu'une deuxième unité de modulation de la largeur d'impulsion (2, 3), l'unité de commande (1) étant configurée de telle façon qu'elle génère un signal de réglage (pwm1) pour la première unité de modulation de largeur d'impulsion (2) et un signal de réglage (pwm2) pour la deuxième unité de modulation de la largeur d'impulsion (3), la première ou la deuxième unité de modulation de la largeur d'impulsion (2, 3) étant configurée de telle façon qu'elle règle la largeur d'impulsion du premier ou du deuxième signal de commande ($V_H$, $V_L$) amené au circuit transformateur de tension (4) en fonction du signal de réglage correspondant (pwm1, pwm2) et le circuit transformateur de tension (4) étant configuré de telle façon qu'il relève la tension de son signal de sortie ($V_{OUT}$) en fonction de la largeur d'impulsion du premier signal de commande ($V_H$) amené par la première unité de modulation de la largeur d'impulsion (2) ou l'abaisse en fonction de la largeur d'impulsion du deuxième signal de commande ($V_L$) amené par la deuxième unité de modulation de la largeur d'impulsion (3).

4. Montage selon l'une quelconque des revendications précédentes, **caractérisé en ce que** les éléments de commande (1-3) sont configurés de telle façon qu'ils génèrent le premier et le deuxième signal de commande ($V_H$, $V_L$) pour le circuit transformateur de tension (4) avec une fréquence variable.

5. Montage selon la revendication 4, **caractérisé en ce que** les éléments de commande (1-3) comprennent une unité de commande (1) ainsi qu'une première et une deuxième unité de modulation de la largeur d'impulsion (2, 3) et **en ce que** l'unité de commande (1) est configurée de telle façon qu'elle génère un signal de réglage (f1) pour la première unité de modulation de la largeur d'impulsion (2) et un signal de réglage (f2) pour la deuxième unité de modulation de la largeur d'impulsion (3), la première ou la deuxième unité de modulation de la largeur d'impulsion (2, 3) étant configurée de telle façon qu'elle règle la fréquence du premier ou du deuxième signal de commande ($V_H$, $V_L$) amené au circuit transformateur de tension (4) en fonction du signal de réglage correspondant (f1, f2) et le circuit transformateur de tension (4) étant configuré de telle façon qu'il relève la tension de son signal de sortie ($V_{OUT}$) en fonction de la fréquence du premier signal de commande ($V_H$) amené par la première unité de modulation de la largeur d'impulsion (2) ou l'abaisse en fonction de la fréquence du deuxième signal de commande ($V_L$) amené par la deuxième unité de modulation de la largeur d'impulsion (3).

6. Montage selon l'une quelconque des revendications précédentes, **caractérisé en ce que** le circuit transformateur de tension (4) comprend un circuit en série fonctionnant avec une tension d'alimentation ($V_o$) et se composant d'une inductance (L) et d'un premier commutateur à semi-conducteurs pouvant être commandé (T1), alors qu'un circuit en série se composant d'un élément redresseur (D) et d'une capacité (C) est placé en parallèle avec le premier commutateur à semi-conducteurs pouvant être commandé (T1) et que la tension du signal de sortie ($V_{OUT}$) du circuit transformateur de tension (4) peut être prélevée sur la capacité, qu'un deuxième commutateur à semi-conducteurs pouvant être commandé (T2) est placé en parallèle avec la capacité (C) et que le premier commutateur à semi-conducteurs pouvant être commandé (T1) est activé par le premier signal de commande ($V_H$) et le deuxième commutateur à semi-conducteurs pouvant être commandé (T2) activé par le deuxième signal de commande ($V_L$).

7. Montage selon la revendication 6, **caractérisé en ce que** le premier et le deuxième commutateur à semi-conducteurs pouvant être commandé sont formés respectivement par un transistor bipolaire (T1, T2), alors que l'émetteur du premier transistor bipolaire (T1) formant le premier commutateur à semi-conducteurs est relié avec l'émetteur du deuxième transistor bipolaire (T2) formant le deuxième commutateur à semi-conducteurs, que le collecteur du premier transistor bipolaire (T1) est relié avec l'un des points de connexion de l'élément redresseur (D) et le collecteur du deuxième transistor bipolaire (T2) est relié par l'intermédiaire d'une résistance (R3) avec l'autre point de connexion de l'élément redresseur (D) et que le premier signal de commande ($V_H$) est appliqué à la base du premier transistor bipolaire (T1) et le deuxième signal de commande ($V_L$) est appliqué à la base du deuxième transistor bipolaire (T2).

8. Montage selon la revendication 7 et la revendication 3, **caractérisé en ce que** les éléments de commande (1-3) sont configurés de telle façon qu'ils génèrent le premier et le deuxième signal de commande ($V_H$, $V_L$) pour le circuit transformateur de tension (4) sans exploitation du signal de sortie ($V_{OUT}$) du circuit transformateur de tension (4) mais en fonction d'un signal de référence ($V_{REF}$), **en ce que** la première ou la deuxième unité de modulation de la largeur d'impulsion (2, 3) génère le premier ou le deuxième signal de commande ($V_H$, $V_L$) avec une fréquence constante et **en ce que** l'unité de commande (1) est configurée de telle façon qu'elle détermine au moins approximativement la largeur d'impulsion de la première ou de la deuxième unité de modulation de la largeur d'impulsion (2, 3)

$$-\frac{L}{R_{EC} \cdot T} \cdot \ln\left(1 - \frac{R_{EC}}{V_o} \cdot \sqrt{\frac{C}{L}\left(x^2(k) - x^2(k-1)\right)}\right)$$

selon la formule
au cas où x(k) > x(k-1) alors qu'elle détermine au moins approximativement la largeur d'impulsion de la première ou de la deuxième unité de modulation de la largeur d'impulsion (2, 3) selon la formule

$$-\frac{R \cdot C}{T} \cdot \left(\ln(x(k-1)) - \ln(x(k))\right)$$

au cas où x(k) < x(k-1), C désignant la valeur de la capacité, L la valeur de l'inductance, R la valeur de la résistance, $R_{EC}$ la valeur de la résistance émetteur-collecteur du premier transistor bipolaire (T1), $V_0$ la valeur de la tension d'alimentation, 1/T la valeur de la fréquence de la première et de la deuxième unité de modulation de la largeur d'impulsion (2, 3) et x(k) la valeur du signal de référence au moment k.

9. Montage selon l'une quelconque des revendications 1-7, **caractérisé en ce que** les éléments de commande (1-3) sont configurés de telle façon qu'ils comparent le signal de sortie ($V_{OUT}$) du circuit transformateur de tension (4) avec un signal de référence ($V_{REF}$) et génèrent le premier et le deuxième signal de commande ($V_H$, $V_L$) pour le circuit transformateur de tension (4) en fonction du résultat de la comparaison.

10. Montage selon la revendication 9 et la revendication 3 ou 5, **caractérisé en ce que** l'unité de commande (1) est configurée de telle façon qu'elle compare le signal de sortie ($V_{OUT}$) du circuit transformateur de tension (4) avec un signal de référence ($V_{REF}$) et génère en fonction du résultat de la comparaison le signal de réglage (pwm1, f1) pour la première unité de modulation de la largeur d'impulsion (2) et le signal de réglage (pwm2, f2) pour la deuxième unité de modulation de la largeur d'impulsion (3).

11. Montage selon la revendication 7 et la revendication 10, **caractérisé en ce que** la première ou la deuxième unité de modulation de la largeur d'impulsion (2, 3) génère le premier ou le deuxième signal de commande ($V_H$, $V_L$) avec une fréquence constante et **en ce que** l'unité de commande (1) est configurée de telle façon qu'elle détermine au moins approximativement la largeur d'impulsion de la première ou de la deuxième unité de modulation de la largeur d'impulsion (2, 3) selon la formule

$$\sqrt{2 \cdot C \cdot L \cdot \left(2 \cdot e(k) \cdot y(k) + e(k) \cdot e(k)\right)} / \left(T \cdot V_0\right)$$

au cas où e(k) > 0 alors qu'elle détermine au moins approximativement la largeur d'impulsion de la première ou de la deuxième unité de modulation de la largeur d'impulsion (2, 3) selon la formule

$$-R \cdot C \cdot \ln\left(y(k) / (y(k) + e(k))\right) / T$$

au cas où e(k) < 0, C désignant la valeur de la capacité, L la valeur de l'inductance, R la valeur de la résistance,

$V_0$ la valeur de la tension d'alimentation, 1/T la valeur de la fréquence de la première et de la deuxième unités de modulation de la largeur d'impulsion (2, 3), e(k) la valeur du signal de différence au moment k et y(k) la valeur du signal de sortie du circuit à transformateurs de signaux (4) au moment k.

**12.** Montage selon la revendication 11, **caractérisé en ce que** la fréquence de la première et de la deuxième unités de modulation de la largeur d'impulsion (2, 3) est de 128 kHz.

**13.** Utilisation d'un montage selon l'une quelconque des revendications précédentes pour créer les tonalités dans un téléphone.

# FIG 1

pwm1

V$_{REF}$

1

f1

PWM-Einheit

2

V$_H$

4

Spannungs-wandler

V$_{OUT}$

Steuereinheit

PWM-Einheit

V$_L$

f2

3

pwm2

# FIG 2

L

D

V$_H$

R1

T1

R3

C

V$_{OUT}$

V$_0$

V$_L$

R2

T2

4

# FIG 3A

# FIG 3B